Europäisches Patentamt

(19) European Patent Office

Office européen des brevets

(11) Publication number: **0 289 601 B1**

## (12) EUROPEAN PATENT SPECIFICATION

(45) Date of publication of patent specification :
10.07.91 Bulletin 91/28

(51) Int. Cl.⁵ : **H01G 4/24**

(21) Application number : **86906952.6**

(22) Date of filing : **27.11.86**

(86) International application number :
**PCT/JP86/00607**

(87) International publication number :
**WO 87/03419 04.06.87 Gazette 87/12**

(54) ZINC-METALLIZED BASE MATERIAL FOR METALLIZED CAPACITOR AND PROCESS FOR ITS PRODUCTION.

(30) Priority : 30.11.85 JP 270565/85

(43) Date of publication of application :
09.11.88 Bulletin 88/45

(45) Publication of the grant of the patent :
10.07.91 Bulletin 91/28

(84) Designated Contracting States :
FR

(56) References cited :
FR-A- 1 431 712
FR-A- 2 405 546
GB-A- 1 016 734

(73) Proprietor : HONSHU SEISHI KABUSHIKI
KAISHA
12-8, Ginza 5-chome Chuo-ku
Tokyo 104 (JP)

(72) Inventor : NAGAI, Susumu
3457-1, Nakatsugawa
Nakatsugawa-shi Gifu 508 (JP)
Inventor : IBARAKI, Takamasa
1285 2-901, Minami-shinozaki-cho
Edogawa-ku Tokyo 133 (JP)
Inventor : KAMOTANI, Hisatoshi
2811-1, Nakatsugawa
Nakatsugawa-shi Gifu 508 (JP)
Inventor : YAMAUCHI, Tsunetatsu
36-14, Tegano
Nakatsugawa-shi Gifu 508 (JP)
Inventor : IMAI, Makoto
2811-1, Nakatsugawa
Nakatsugawa-shi Gifu 508 (JP)

(74) Representative : Kedinger, Jean-Paul et al
c/o Cabinet Malemont 42, avenue du Président
Wilson
F-75116 Paris (FR)

## Description

BACKGROUND OF THE INVENTION

The present invention relates to a zinc-metallized film and a vacuum-deposited zinc metallized paper for metallized capacitors (hereinafter called "zinc-metallized base material for capacitors" generically), and is particularly concerned with a zinc-metallized base material for capacitors functioning remarkably well from using on heat-pressed capacitor elements and a process for its production.

TECHNICAL FIELD

A metallized base material for use on capacitors for which an electrode is formed from vacuum depositing a metal such as zinc, aluminum or the like on a film such as polypropylene film, polyester film and the like or on a thin capacitor paper is very popular presently. A thickness of a vacuum-deposited metal layer of the base material is very thin normally as 100 to 600 Å, therefore it is easily turnable to hydroxide or oxide due to water content or oxygen in the air when left as it stands, and an electric conductivity deteriorates consequently to be of no service as a capacitor electrode. It is severely denatured when left for a long time under high-temperature and high-humidity conditions in a half-finished state as a winding material or capacitor element particularly at the time of capacitor manufacture.

The most general metals for vacuum-depositing includes aluminum and zinc, however, while outstanding for electrical characteristics that a capacitance variation is minimized when used on a capacitor, a current resistance is high and so forth as compared with aluminum, zinc is inferior particularly in a resistance to humidity.

In view of the circumstances above, manufacturers of the metallized base material are in a strict quality control so as not to invite the aforementioned denaturation on the base material as product, and the fact is that the metallized base material is packaged in a high barrier film with less humidity permeability and oxygen permeability for better packaging mode to secure firstly, a descating agent (such as silicagel or the like) is sealed in the interior of package so as to lower humidity to warehousing and carrying, and further the warehousing temperature is controlled not to exceed 30°C actually. Thus, direct measures for preventing the aforementioned metallized base material from being denatured (deteriorated) by humidity absorption and oxidation are not taken hitherto, attention is paid solely to a packaging control for storage to secure, thus coping with the situation through an indirect method in a sense.

DICLOSURE OF THE INVENTION

In view of the actual circumstances mentioned above, the invention is intended for solving the aforementioned problem directly instead of taking the indirect means for prevention of denaturation as mentioned. That is, according to the aforementioned means, the metallized base material is exposed to denaturation once unpacked and hence must be used as quickly as possible, and still worse, temperature and humidity must be taken into consideration even in the process for manufacturing capacitors, thus involving various problems otherwise. In order to settle such problems throughly, the inventors provide such means as will prevent humidity absorption and oxidation from arising thereafter by forming a protective layer on the surface of the metallized base material concurrently with or after manufacture of the base material.

Mean while the invention is to solve the problems by employing technical means as defined in the scope of claim, however, the following case has been found to have something to do with the invention by the inventors, which will be referred to hereunder accordingly. That is, the case referes to an invention relating to a metallized film for AC capacitor disclosed in Japanese Patent Laid-Open No.Sho59-227115 which is not to intend for handling as the metallized base material but to take the following means in view solely of a working mode of the capacitor as finished product. A working voltage range of the capacitor expands lately, and according as the case where it is used at a high potential gradient is on the way to increase, the surface of a metallic electrode such as aluminum, zinc or the like changes partly by a sort of oxide, loses a function as the electrode consequently to turn to an electric insulator, and under recognition that a decrease in capacitance may result in this case, the metallized layer should be prevented from failure and oxidation by metallizing zinc or aluminum on a polypropylene film and providing an organic insulation layer such as resin, silicone oil or the like further thereon to a certain thickness. However, there is proposed only a solution whereby PET or PP 1,000 Å thick is for insulation in case the capacitance variation after 500 hours comes at 4% or below as a concrete means for solving the problem, and hence it is never recognized pratically as solving the problem that the present invention intends.

Beside, the invention also aims at removing a disadvantage at the time of heat setting which is capable of

2

EP 0 289 601 B1

being a serious problem when a zinc-metallized base material of this kind is used on a heat-pressed capacitor. Now, as is known well, the heat-pressed capacitor is manufactured from having a zinc-metallized film wound thereon when a capacitor element is manufactured and then subjected to a heat-press normally at 100 to 180°C in temperature and 15 to 100 kg/cm² in pressure. In this case, a disadvantage may arise on the contrary simply from, for example, applying oils such as silicone oil and the like on the surface of base material. That is, since an organic matter such as the aforementioned oil or the like reevaporates in the capacitor element at the time of heat-press, a void arises from the heat setting which is not performed in order due to a cubical expansion, thus causing an internal discharge easily. In case the capacitor is manufactured in such state, the metallized layer is fractured due to a heat generated by the internal discharge during use, and the life is considerably shortened by an increase of loss due to discharge. Thus, it is apparent that the above-mentioned means is still not proper as the art for obtaining a metallized base material for the heat-pressed capacitor and hence is not to lead to a solution of the problem.

The circumstances being such as mentioned, the inventors have developed a novel processing means whereby a humidity resistance of the metallized base material for which a strict control of handling is required hitherto can sharply be improved without deteriorating the electrical characteristics, and at the same time the above-mentioned disadvantage will never arise even in case the metallized base material is used for the heat-pressed capacitor.

That is, upon making a study earnestly of each problem mentioned above, the inventors have found that the problems pointed out as above can be solved by an arrangement wherein a vacuum-deposited zinc layer is formed on at least one side of the base material composed of a film or thin capacitor paper, and a material having an extremely limited vapor pressure is built up thereon to a specified thickness. More specifically, a humidity resistance is improved by forming a surface protective layer consisting of oils having 0.1 mmHg vapor pressure at a temperature range 150 to 290°C on the vacuum-deposited layer to the thickness of 7 to 500 Å, an excessively prudent handling is not required unlike the prior art one, and finally obtained is proper zinc-metallized base material free from any disadvantage when used as a zinc-metallized base material for the heat-pressed capacitor.

For obtaining the aforementioned base material, the invention further proposes a process wherein a vacuum-deposited zinc layer is formed at least on one side of the base material composed of a film or thin capacitor paper in vacuum-depositing apparatus, and then oil such as dimethylsilicone oil, silicone oil for the vacuum pump or the like, fatty acid, salts of fatty acid or praffin wax is subjected to a vacuum deposition to the thickness of 7 to 500 Å by the same vacuum-depositing apparatus, and according to the aforementioned process, the product in view is obtainable industrially with ease and steadily.

As described hereinabove, the invention is intended for enhancing the performance with reference to zinc generalized as a vacuum-depositing metal along with aluminum, which is superior in electrical characteristics such that a capacitance variation when used on the capacitor is minimized and a current resistance is satisfactory as compared with aluminum, but is inferior to aluminum in the aspect of moisture resistance.

Meanwhile, as described hereinabove, the invention is characterized in that a specific material such as oil or the like having 0.1 mmHg vapor pressure at the temperature range 150 to 290°C is provided on the surface of a vacuum-deposited zinc layer, therefore the vapor pressure may change according as a molecular weight changes even in the case of a material of the same kind as the above-mentioned, and when it comes outside the range limited by the invention, a product intended by the invention is no more obtainable. That is, in case the temperature corresponding to the 0.1 mmHg vapor pressure of oil does not reach 150°C, evaporation in the heat press process becomes active at the time of capacitor manufacture, a void arises for cubical expansion, which is ready for internal discharge to being unserviceable any more. Then, if the temperature exceeds 290°C, the whole apparatus must be structured to withstand high temperatures for evaporating oils on a vacuum-depositing apparatus or the like, which is not practical from a big construction unavoidable with the apparatus. Further, another problem may arise on a heat resistance of the oil itself.

Oils referred to in the invention are not particularly limited subject to the vapor pressure coming within the aforementioned range, however, oils such as dimethylpolysiloxane, other methylphenyl polysiloxane, silicone oil for vacuum pump and the like are preferable, and fatty acid, salts of fatty acid and wax are also recommendatory. As fatty acid and salts of fatty acid, for example, stearic acid, palmitic acid, oleic acid and its metal salt, zinc, calcium, copper, and lithium salt may be taken up.

The base material used in the invention is a film or thin capacitor paper. The film is not particularly limited, however, polyester film, polypropylene film, polycarbonate film and the like are preferable. Needless to say, the film surface may be subjected to a corona discharge thereon, thereby enhancing a sticking force of the vacuum-deposited zinc.

Then, the aforementioned surface protective layer is formed to the thickness of 7 to 500 Å, however, the thickness coming less than 7 Å is not effective in preventing oxidation of the vacuum-deposited zinc layer, and

3

thus the humidity resistance the invention intends cannot be improved thoroughly. When exceeding 500 Å to the contrary, tan δ characteristic of the capacitor deteriorates, while the humidity resistance is improved. That is, if the protective layer is too thick, then the oils applied on the capacitor element are reevaporated on heat after heat pressing at the time of capacitor manufacture. Thus, a uniform heat setting is not secured, and a multiplicity of fine voids may remain internally as a result, therefore tan δ particularly in a domain where corona discharge at 300 V or over arises sharply increases to being unserviceable any further. It is very important that the surface protective layer should be provided as thin as possible and also uniformly so as to ensure a satisfactory electrical characteristic and moisture resistance therefor, and various methods are conceivable. For example, a method on roll coater may be taken up, however, in view of the fine thickness, a method whereby the aforementioned material is sprayed in mist on the surface of the vacuum-deposited zinc layer to formation is preferable. However, vacuum depositing developed by the inventors will be such method as is best for operation stable industrially, which will be described below in detail.

## BRIEF DESCRIPTION OF THE DRAWINGS

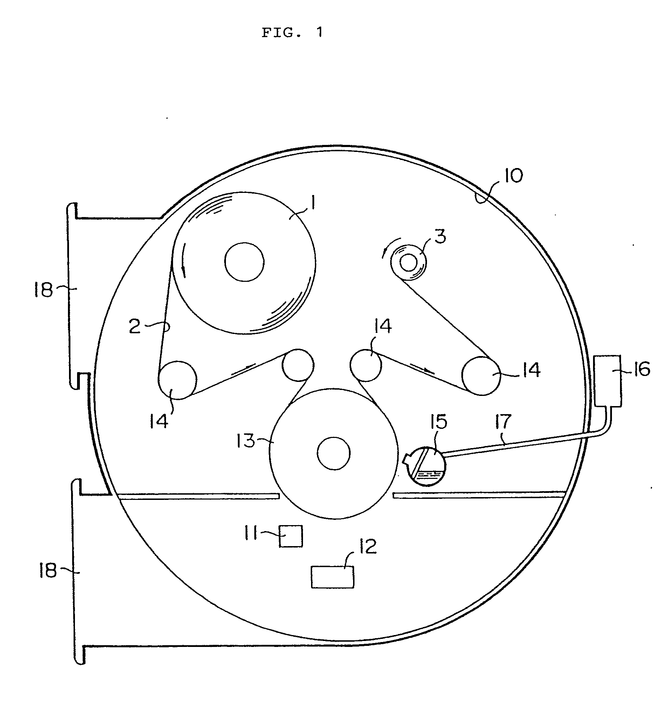

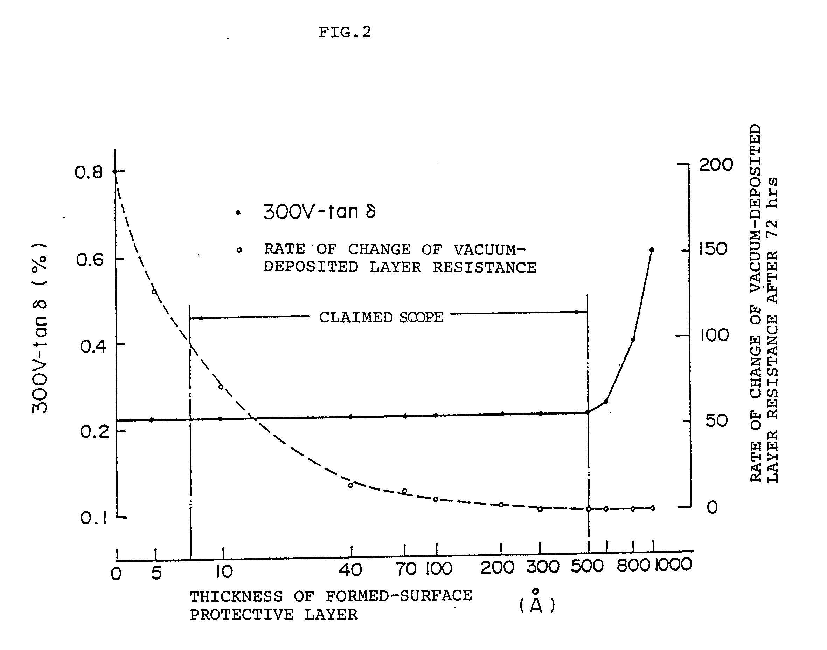

Fig. 1 is a sectional view of a vacuum depositing apparatus given in one example where a process according to the invention is put into practice ; Fig. 2 is a graph with the thickness of a surface protective layer taken on the quadrature axis and 300V-tan δ and a variation of a vacuum-deposited layer resistance taken on the axis of ordinates.

## BEST MODE FOR CARRYING OUT THE INVENTION

Fig. 1 is a sectional view of a vacuum-depositing apparatus given in one preferred embodiment of the invention to put into practice, and in the drawing, a base material 2 delivered from an unreeler 1 has copper or silver nucleating through a nucleus evaporating source 11 metallized preliminarily thereon in vaccuum 1,33 to 0,133 N/cm² (10⁻² to 10⁻³ Torr) formed within a body of a vaccum-depositing apparatus 10 and is then subjected to a regular metallizing controlled to 100 Å to 600 Å in thickness at a zinc evaporating source 12. A reference numeral 13 denotes a cooling roll, and 14 denotes a guide roll.

In the invention, an oil is evaporated by an oil coater 15 provided within the same vacuum-depositing apparatus 10 uninterruptedly to the aforementioned process, and immediately after a zinc-metallizing process, an oil surface protective layer is formed in superposition on the vacuum-deposited zinc layer to the thickness of 7 to 500 Å. Then, the oil has an inherent vapor pressure according to the temperature by heating the coater 15 under above described degree of vacuum within the vacuum-depositing apparatus, therefore the quantity of evaporation can be controlled arbitrarily and the coating thickness can be changed thereby. Thus, after the protective layer is formed on the surface of the vacuum-deposited zinc layer, it is taken up on a reel 3, and a zinc-metallized base material for capacitors of the invention is manufactured accordingly. A reference numeral 16 in the drawing denotes an oil storage tank, 17 denotes a feed pipe therefor, and 18 denotes an exhaust port.

The base material for capacitors which is used in the invention comes in polyester film, polypropylene film, polycarbonate film and the like other than a thin capacitor paper ued normally, and these are fed to the continuous vacuum depositing apparatus to a product according to the aforementioned process.

Then, according to the invention, the zinc-metallizing process and the surface protective layer forming process described above can be applied also on the back thereof, and if so, then a metallized base material with the vacuum-deposited zinc layer and the protective layer on both sides will be obtainable. As described, a thickness of the protective layer is determined according to the quantity of evaporation of oils, however, the quantity of evaporation can easily be controlled through heating temperature. Accordingly, a protective layer very thin and uniform can be formed easily on the zinc-metallized film.

## EMBODIMENT

The invention will now be described in detail further with reference to the embodiment, and for measuring tan δ, the base material obtained through the invention is wound according to a normal process and then subjected to a heat press at 150°C and 30 kg/cm² for 10 minutes, zinc is sprayed as a particle to an end surface of the wound capacitor element by an arc metalikon device, a lead wire is then connected to make a 2.5 μF capacitor as prototype, which is subjected to the measurement by means of a shading bridge in the atmosphere of 23°C.

Example 1

Zinc was vacuum-deposited to the thickness of 400 Å on one side of a polyester film 5 μm thick according to a normal process. Further, a zinc-metallized base material for capacitors of the invention was obtained through forming a surface protective layer 7 to 500 Å thick in the identical vacuum-depositing apparatus on which zinc was vacuum-deposited by means of oils shown in Table 1, and then moisture resistance and value of tan δ were obtained through measurement thereon. The result is given in Table 2 and Fig. 2. For appreciation of the moisture resistance, the base material was allowed to stand in the atmosphere of 70°C and 65% RH, and a resistance value of the metallized film was measured with the lapse of time. As a comparative example, a protective layer was formed by means of oils outside the range limited by the invention, a zinc-metallized material for capacitors was made exactly in the same way as the embodiment otherwise, and then values were measured for similar measuring items.

Table 1

| Sym-bol | Component | Trade name (*) | Temperature cor-responding to vapor pressure at 0.1mmHg | Appreciation | | Remarks |
|---|---|---|---|---|---|---|
| | | | | $\Delta MR/MRo$ (%) | tan $\delta$ (%) | |
| A | Petroleum fraction | Neovac ME-250(*1) | 100°C | 105 | 0.28 | |
| B | " | Neovac ME-300 " | 140 " | 100 | 0.26 | |
| C | " | Neovac MR-100 " | 148 " | 100 | 0.25 | No good for heat deterioration |
| D | Dimethylpoly-siloxane | KF-96L 2CS (*2) | 75 " | 110 | 0.31 | Silicone oil |
| E | " | KF-96 10CS " | 130 " | 105 | 0.26 | " |
| F | " | KF-96 20CS " | 222 " | 50 | 0.22 | " |
| G | " | KF-96 50CS " | 260 " | 45 | 0.22 | " |
| H | " | KF-96 100CS " | 285 " | 35 | 0.21 | " |
| I | " | KF-96 500CS " | 350 " | - | - | Deteriorates in heat resistance at evapo-rating temperature of silicone oil |
| J | Methylphenyl polysiloxane | DC-702 (*3) | 185 " | 30 | 0.21 | Silicone oil |
| K | " | HIVAC F4 (*2) | 180 " | 25 | 0.22 | " |
| L | " | HIVAC F5 (*2) | 210 " | 15 | 0.22 | " |
| M | Alkylnaphthylene | LION A (*4) | 180 " | 40 | 0.21 | |
| N | Polydiphenylether | SKA (*1) | 160 " | 50 | 0.23 | |
| O | Stearic acid | Guaranteed reagent | 151 " | 65 | 0.21 | |

Appreciation: $\Delta MR/MRo$ (%) ... Rate of change after 72 hours to initial vacuum-deposited layer resistance value MRo. Practical range is 100% or below.

tan $\delta$ (%) ..... Dielectric loss tangent of heat press type dry capacitor at 300V and 60Hz. Practical range is 0.24% or below.

* ... Name of manufacturers: (*1) ... Matsumura Sekiyu, (*2) ... Shin-etsu Chemical Ind. (*3) ... Toray Silicone, (*4) ... Lion

## Table 2

| Item | | Thickness of surface protective layer (Å) | Voltage-tan δ (%) at 23°C and 60Hz | | | Moisture resistance test | | |
|------|---|---|---|---|---|---|---|---|
| | | | | | | Rate of change of vacuum-deposited layer resistance (%) | | |
| | | | 100V | 200V | 300V | After 24 hrs | After 48 hrs | After 72 hrs |
| Comparative example | | 5 | 0.198 | 0.199 | 0.225 | 25 | 55 | 130 |
| Operative example | 1 | 10 | 0.199 | 0.201 | 0.223 | 20 | 45 | 75 |
| | 2 | 40 | 0.197 | 0.201 | 0.226 | 15 | 25 | 35 |
| | 3 | 70 | 0.198 | 0.200 | 0.224 | 6 | 13 | 24 |
| | 4 | 100 | 0.197 | 0.198 | 0.221 | 3 | 9 | 15 |
| | 5 | 200 | 0.196 | 0.199 | 0.227 | 1 max. | 4 | 8 |
| | 6 | 300 | 0.197 | 0.202 | 0.229 | " | 1 max. | 1 |
| | 7 | 500 | 0.196 | 0.203 | 0.230 | " | " | 1 |
| Comparative example | 1 | 600 | 0.197 | 0.205 | 0.250 | " | " | 1 max. |
| | 2 | 800 | 0.209 | 0.214 | 0.394 | " | " | " |
| | 3 | 1000 | 0.213 | 0.220 | 0.603 | " | " | " |
| Existing goods | | 0 | 0.198 | 0.200 | 0.224 | 50 | 150 | 200 |

Oils with symbol K in Table 1 are used for operative examples.

As will be apparent from Table 2 and Fig. 2, the film resistance value sharply changes where the surface protective layer of the invention is not provided, and an effect in improving the humidity resistance is also not expectable where a coated thickness is less than 7 Å. On the other hand, it has been clarified that while an effect in improving the moisture resistance is appreciated, tan δ rises strikingly at 300V to being unserviceably practically where the thickness is greater than 500 Å.

## Example 2

An example of the circular capacitor element will be described next. Zinc was vacuum-deposited to the thickness of 280 Å on one side of a polyester film 4.5 μm thick, and then the silicone oil indicated by K in Table 1 was applied to the thickness 200 Å on the metallized surface through vacuum deposition, thus obtained a surface protective layer. The base material was slit to 70 mm in width and taken up as in the case of normal zinc-metallized film.

A capacitor element was wound from the zinc-metallized film, a zinc particle was sprayed on an end surface of the element, mounted with a lead wire then and subjected to a vacuum drying in an aluminum case, thus obtaining a capacitor 70 μF in capacitance impregnated with polybutene oil to appreciation.

Electrical characteristics compared with the existing goods are shown in Table 3 ; wherein equivalent characteristics are ensured. On the other hand, from subjecting products according to the example to appreciation under high-temperature and high-humidity conditions for checking the effect in improving the humidity resistance, it has been confirmed that the products have the humidity resistance sharply enhanced as compared with the existing goods. The result is shown in Table 3. The test was carried out such that the products according to the example and the existing goods were wound 30 turns each, allowed to stand in the atmosphere of 70°C and 65% RH for 24 hours and 72 hours, and then a variation of the metallized film resistance was observed.

Table 3

| Characteristic | Capacitance | Room temp. tan δ (%) | | 75°C tan δ (%) | | Rate of change of vacuum-deposited layer resistance | |
|---|---|---|---|---|---|---|---|
| | (µF) | 200V | 300V | 200V | 300V | After 24 hrs | After 72 hrs |
| Operative example (Invention) | 71.2 | 0.210 | 0.224 | 0.130 | 0.150 | 4% | 11.3% |
| Comparative example (Existing goods) | 70.5 | 0.207 | 0.217 | 0.127 | 0.143 | 24% | 559% |

Meanwhile, the operative examples in Tables 1 to 3 indicate a case where zinc-metallized films 4.5 µm and 5 µm thick are used as typical dielectrics, however, a base film working as the metallized base material or a thin capacitor paper working as the base such as zinc evaporated polypropylene film, zinc-metallized polycarbonate film or the like used normally can also be used other than these examples, and hence it is not to be so specified. Similarly, the oils are not necessarily limited, and such silicone oil and wax as will have a vapor pressure characteristic at 0.1 mmHg at the temperature range 150 to 290°C described hereinabove can be utilized satisfactorily. Then, the oil used for the aforementioned examples is a vacuum pump oil placed generally on the market.

As described in detail above, the invention comprises forming a protective film layer composed of a specific material for improving humidity resistance to the predetermined thickness on the surface of a zinc-metallized base material for capacitors, therefore it is effective enough to be almost free from troubles for product control as the zinc-metallized base material which is vital hitherto and particularly for control on temperature and humidity under a strict packaging. In other words, the invention is most useful in suggesting that a substantial improvement of humidity resistance for the zinc-metallized base material for which remarkable measures have not been taken hitherto can be proposed.

Further, it is significant industrially in respect particularly of solving defect and trouble such as denaturation of deposition due to oxidation of the zinc-metallized film during capacitor manufacturing process or in stock which has occurred hitherto as described and rise in the metallized film resistance as well.

Moreover, the invention is effective to have appreciated zinc superior in electrical characteristic and others but falling behind aluminum for the property easy to denature practically available to serving as a deposited metal for capacitors better than aluminum.

According to the invention, furthermore, a normal quantity of oil can be applied to a steady state industrially on the zinc-metallized film extremely thin, uniformly and so easily, therefore the base material is applicable straight as a base material for use on heat-pressed capacitors.

According to the invention, still further, the feature is that oils will be applied to the width limited to come within 7 Å to 500 Å, and a coat film with an extremely thin screening effect is formed, however, a means for realizing the feature easily and stably is provided at the same time by controlling degree of vacuum or evaporating temperature of oils, and since the working is carried out within a vacuum-depositing apparatus, the method is free from giving rise to a fatal defect on insulation from having the base film utilized as a dielectric for the capacitor contaminated by dust and dirt, and thus a method advantageous by far as compared with the case where oils are applied in the atmosphere can be provided accordingly.

**Claims**

1. A zinc-metallized base material for metallized capacitors comprising :
a base material being composed of a thin polymeric film or paper ;
a vacuum-deposited zinc layer being formed on at least one side of said base material ; and being characterised by
a surface protective layer being formed on said vacuum-deposited zinc layer, said surface protective layer being provided with a thickness of 7 to 500 Å and being formed by a material having a vapor pressure of [0.1 mmHg] at a temperature within the range of 150 to 290°C so as to improve humidity resistance.

2. A zinc-metallized base material for metallized capacitors as claimed in Claim 1, wherein said surface protective layer is formed of an oil such as a dimethylsilicone oil or a silicone oil for a vacuum pump.

3. A zinc-metallized base material for metallized capacitors as claimed in Claim 1, wherein said surface protective layer is formed of a fatty acid, a salt of a fatty acid or paraffin wax.

4. A process for producing said zinc-metallized base material of claim 1 comprising the steps of :

forming said vacuum-deposited zinc layer on at least one side of said base material in a vacuum-depositing apparatus ; and

vacuum-depositing said surface protective layer on said vacuum-deposited zinc layer by the same vacuum-depositing apparatus, said surface protective layer being provided to the thickness of 7 to 500 Å and being formed of an oil such as a dimethylsilicone oil or a silicone oil for the vacuum pump or a fatty acid, a salt of a fatty acid or paraffin wax.

## Patentansprüche

1. Ein zink-metallisiertes Basismaterial für metallisierte Kondensatoren umfassend

ein Basismaterial bestehend aus einem dünnen Polymerfilm oder Papier ;

einer vakuumbedampften Zinkschicht, die auf mindestens einer Seite des Basismaterials ausgebildet ist;

und **gekennzeichnet durch**

eine Oberflächenschutzschicht, die auf der vakuumbedampften Zinkschicht ausgebildet ist, wobei die Oberflächenschutzschicht mit einer Dicke von 7 bis 500 Å ausgestattet ist und durch ein Material mit einem Dampfdruck von 0,1 mm Hg bei einer Temperatur in dem Bereich von 150 bis 290°C gebildet wird, um die Widerstandsfähigkeit gegen Feuchtigkeit zu verbessern.

2. Ein zink-metallisiertes Basismaterial für metallisierte Kondensatoren wie in Anspruch 1 beansprucht, worin die Oberflächenschutzschicht aus einem öl, wie einem Dimethylsilikonöl oder einem Silikonöl für eine Vakuumpumpe, gebildet ist.

3. Ein zink-metallisiertes Basismaterial für metallisierte Kondensatoren wie in Anspruch 1 beansprucht, worin die Oberflächenschutzschicht aus einer Fettsäure, einem Salz einer Fettsäure oder Paraffinwachs gebildet ist.

4. Ein Verfahren zum Herstellen des zink-metallisierten Basismaterials nach Anspruch 1 umfassend die Schritte : Ausbilden der vakuumbedampften Zinkschicht auf mindestens einer Seite des Basismaterials in einer Vakuumbedampfungsapparatur ; und Vakuumbedampfen der Oberflächenschutzschicht auf der vakuumbedampften Zinkschicht durch dieselbe Vakuumbedampfungsapparatur, wobei die Oberflächenschutzschicht mit einer Dicke von 7 bis 500 Å ausgestattet ist und aus einem Öl, wie einem Dimethylsilikonöl oder einem Silikonöl für die Vakuumpumpe oder einer Fettsäure, einem Salz einer Fettsäure oder Paraffinwachs gebildet ist.

## Revendications

1. Matériau de base métallisé au zinc pour condensateurs métallisés, comportant :

un matériau de base composé d'un film polymérique ou d'un papier mince ;

une couche de zinc déposée sous vide, formée sur l'une au moins des faces dudit matériau de base ; et caractérisé par

une couche protectrice de surface formée sur ladite couche de zinc déposée sous vide, ladite couche protectrice de surface étant appliquée avec une épaisseur de 7 à 500 Å et formée par un matériau ayant une pression de vapeur de 0,1 mmHg à une température comprise dans la plage de 150 à 290°C, afin d'améliorer une résistance à l'humidité.

2. Matériau de base métallisé au zinc pour condensateurs métallisés, selon la revendication 1, dans lequel ladite couche protectrice de surface est formée d'une huile, telle qu'une huile de diméthylsilicone ou d'une huile de silicone pour une pompe à vide.

3. Matériau de base métallisé au zinc pour condensateurs métallisés, selon la revendication 1, dans lequel ladite couche protectrice de surface est formée d'un acide gras, d'un sel d'un acide gras ou de cire de paraffine.

4. Procédé pour produire ledit matériau de base métallisé au zinc selon la revendication 1, comportant les étapes qui consistent à :

former ladite couche de zinc déposée sous vide sur l'une au moins des faces dudit matériau de base, dans un appareil de dépôt sous vide ; et

déposer sous vide ladite couche protectrice de surface sur ladite couche de zinc déposée sous vide à l'aide du même appareil de dépôt sous vide, ladite couche protectrice de surface étant appliquée suivant l'épaisseur de 7 à 500 Å et formée d'une huile, telle qu'une huile de diméthylsilicone ou une huile de silicone pour la pompe à vide, ou d'un acide gras, d'un sel d'un acide gras ou de cire de paraffine.

FIG. 1

FIG.2

THICKNESS OF FORMED-SURFACE PROTECTIVE LAYER (Å)

- 300V-tan δ

∘ RATE OF CHANGE OF VACUUM-
DEPOSITED LAYER RESISTANCE

CLAIMED SCOPE

300V-tan δ (%)

RATE OF CHANGE OF VACUUM-DEPOSITED LAYER RESISTANCE AFTER 72 hrs

EP 0 289 601 B1